Europäisches Patentamt
European Patent Office
Office européen des brevets

(11) Publication number: **0 476 134 A1**

(12) **EUROPEAN PATENT APPLICATION published in accordance with Art. 158(3) EPC**

(21) Application number: **90909359.3**

(22) Date of filing: **14.06.90**

(86) International application number: **PCT/JP90/00777**

(87) International publication number: **WO 90/16086 (27.12.90 90/29)**

(51) Int. Cl.[5]: **H01L 35/16**, H01L 35/18

(30) Priority: **14.06.89 JP 151380/89**

(43) Date of publication of application: **25.03.92 Bulletin 92/13**

(84) Designated Contracting States: **DE FR GB**



(71) Applicant: **KABUSHIKI KAISHA KOMATSU SEISAKUSHO**
**3-6, Akasaka 2-chome**
**Minato-ku Tokyo 107(JP)**

(72) Inventor: **IMAIZUMI, Hisaakira Kabushiki Kaisha Komatsu**
**Seisakusho Research Institution**
**1200, Manda, Hiratsuka-shi Kanagawa 254(JP)**
Inventor: **TANIMURA, Toshinobu Kabushiki Kaisha Komatsu**
**Seisakusho Research Institution**
**1200, Manda, Hiratsuka-shi Kanagawa 254(JP)**
Inventor: **YAMAGUCHI, Hiroaki Kabushiki Kaisha Komatsu**
**Seisakusho Research Institution**
**1200, Manda, Hiratsuka-shi Kanagawa 254(JP)**
Inventor: **FUKUDA, Katsushi Kabushiki Kaisha Komatsu**
**Seisakusho Research Institution**
**1200, Manda, Hiratsuka-shi Kanagawa 254(JP)**

(74) Representative: **Newstead, Michael John**
**Page Hargrave Temple Gate House Temple Gate**
**Bristol BS1 6PL(GB)**


(54) **THERMOELECTRIC SEMICONDUCTOR MATERIAL AND METHOD OF PRODUCING THE SAME.**


(57) A thermoelectric semiconductor material of the invention is constituted of a sinter of a solid solution powder of bismuth telluride ($Bi_2Te_3$) - antimony telluride ($Sb_2Te_3$) or bismuth telluride ($Bi_2Te_3$) - antimony telluride ($Sb_2Te_3$) - antimony selenide ($Sb_2Se_3$) having a uniform particle size obtained by mixing together bismuth, antimony, tellurium, selenium and impurities of one conductivity type at desired composition, heating and melting the mixture, quenching the mixture to form an ingot thereof, pulverizing it to have a uniform particle size, and sintering it under pressure. Therefore, a thermoelectric element thus formed has high mechanical strengths and good characteristics.



EP 0 476 134 A1

SEMICONDUCTOR
METAL
FIGURE OF MERIT Z($10^3K^{-1}$)
SEEBECK COEFFICIENT
a (mV K$^{-1}$) $a^2\delta$ ($10^2WK^{-2}m^{-1}$)
ELECTRIC CONDUCTIVITY log d ($\Omega^{-1}m^{-1}$)
THERMAL CONDUCTTIVITY κ($WK^{-1}m^{-1}$)
a
Z
$a^2\delta$
$\delta=1/\rho$
κ
κph
2.0
1.6
1.2
0.8
0.4
0
1.0
0.8
0.6
0.4
0.2
0
7
6
5
4
3
2
60
50
40
30
20
10
0
21
22
23
24
25
26
27
28
CARRIER CONCENTRATION log n ($m^{-1}$)

FIG. 3

## TECHNICAL FIELD

The present invention relates to a thermoelectric semiconductor material and a method producing the same.

## BACKGROUND ART

Since it has been found that an electronic cooling element having a Peltier effect or an Ettinghausen effect utilized therefor or a thermoelectric power generating element having a Seebeck effect utilized therefor is simple in structure, and moreover, it can easily be handled while maintaining stable properties, an attention has been hitherto paid to its utilization in many application fields. Especially, since the electronic cooling element makes it possible to exactly control local cooling as well as a temperature in the range around the room temperature, research works have extensively been conducted for developing a device which can be used for allowing optoelectronic apparatuses, semiconductor laser light apparatuses or the like to operate at a constant temperature.

A thermoelectric material used for the purpose of electronic cooling is usually produced using a crystalline material. However, this leads to the results that the thermoelectric material is produced on the mass production basis at a low yielding rate and this prevents the thermoelectric material from being practically used in many industrial fields. Specifically, the crystalline material generally used as an electronic cooling element is a mixed crystal based material typically composed of tellurium-bismuth ($Bi_2Te_3$), tellurium-antimoni ($Sb_2Te_3$) and an impurity of selenium-bismuth ($Bi_2Se_3$), but crystals of tellurium-bismuth and selenium-bismuth exhibit a remarkable property of cleavage. For this reason, there arises a problem that a yielding rate is substantially reduced due to cracking or breaking in the course of slicing step and others for producing thermoelectric elements from an ingot. In a case where a crystalline material such as tellurium-bismuth, selenium-bismuth or the like is used, it is practically difficult due to remarkable cleavage inherent to the crystalline material to handle it by operating a machine. Thus, the current status is that the crystalline material is manually handled.

In view of the foregoing current status, many trials have been hitherto conducted for molding a sintered element of powder in order to improve a mechanical strength of the thermoelectric element. When a crystal is not used but the sintered product of powder is used, there does not arise a problem of cleavage but a density of the sintered product of powder fails to be increased. This leads to another problem that a solder penetrates into the interior of the sintered product of powder during a soldering operation, resulting in properties of the sintered product of powder being degraded.

When the sintered product of powder is employed for a thermoelectric element, the grain boundary is grown and enlarged, causing a degree of displacement of carriers to be reduced. For this reason, electrical resistance of the sintered product of powder is increased and Joule heat is increasingly generated. Thus, there arises a problem that a cooling ability of the thermoelectric element is reduced undesirably.

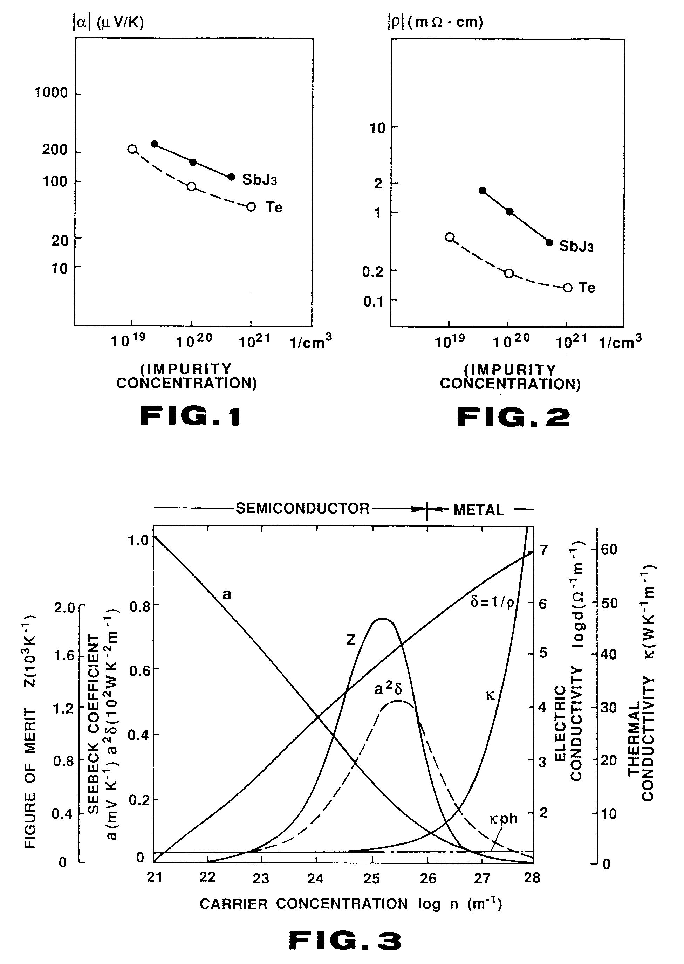

The cooling ability of a thermoelectric material is determined depending on the magnitude of a figure of merit Z ($=\alpha b/\zeta K$) which is represented by a Seebeck coefficient $\alpha$ that is a constant inherent to each material, a specific resistance $\zeta$ and a thermal conductivity K. When a dope quantity of impurities is increased so as to allow the electrical resistance of a sintered product of powder to be restored to an original value, the Seebeck coefficient is decreased, causing the figure of merit to be decreased correspondingly. As is apparent from Fig. 3, the figure of merit and the carrier concentration have an optimum value, and it is very difficult to obtain values which satisfy both the factors.

In addition, in a case where powder is employed for the thermoelectric material, there are problems that doping control is carried out only with difficulty, and moreover, the carrier density fails to be kept constant even when a preset quantity of impurities are added to the powder. In other words, there is a problem that it is practically difficult that a sintered product of powder achieves desired properties with excellent reproducibility when it is produced under same conditions while maintaining a same composition.

The present invention has been made with the foregoing background in mind and its object resides in providing a thermoelectric semiconductor material which assure that doping control can easily be carried out and the thermoelectric semiconductor material can be produced at a high yielding rate.

## DISCLOSURE OF THE INVENTION

According to a first aspect of the present invention, there is provided a thermoelectric semiconductor material which is characterized in that the thermoelectric semiconductor material is composed of a sintered product of monoconductive type powder containing as a main component powder of solid solution of

tellurium-bismuth ($Bi_2Te_3$) and tellurium-antimoni ($Sb_2Te_3$) having an uniform grain size wherein the powder of solid solution contains monoconductive impurities or a content of the impurities is slightly deviated from a stoichiometric ratio.

In addition, according to a second aspect of the present invention, there is provided a thermoelectric semiconductor material which is characterized in that the thermoelectric semiconductor material is composed of a sintered product of monoconductive type powder containing as a main component powder of solid solution of tellurium-bismuth ($Bi_2Te_3$), tellurium-antimoni ($Sb_2Te_3$) and selenium-antimoni ($Sb_2Se_3$) having an uniform grain size wherein the powder of solid solution contains monoconductive impurities or a content of the impurities is slightly deviated from a stoichiometric ratio.

Additionally, according to a third aspect of the present invention, there is provided a method of producing a thermoelectric semiconductor material which is characterized in that the method is practiced by way of steps of mixing bismuth, antimoni, tellurium, selenium and monoconductive impurities with each other while maintaining a desired composition and then heating and melting the resultant mixture, quickly cooling the molten mixture to prepare a solid solution in the form of an ingot, crushing and grinding the resultant ingot to prepare powder of the solid solution, then, sieving the powder of solid solution so as to allow the powder of solid solution to have an uniform grain size, and finally sintering the powder of solid solution while compacting it.

It is preferable that when the molten mixture of solid solution is to be cooled, it is quickly cooled down to a temperature lower than a solidification temperature of the molten mixture.

In general, when a grain size of powder is increasingly reduced, a thermal conductivity K becomes smaller but a specific resistance $\rho$ becomes larger. The present invention has been made in consideration of the fact that the thermal conductivity K can not be reduced to such an extent that increase of the specific resistance $\rho$ is properly compensated.

The inventors have found out based on the results derived from elaborate examinations that when $(Bi, Sb)_2(Te, Se)_3$ based powder is ground to grains having a grain size having an order of submicrons, remarkable oxidative adsorption is recognized, electrical properties of the powder are extremely degraded, and moreover, reproducibility of the properties of powder is achieved only with difficulty.

Further, the inventors have found out that when the grain size of the ground powder is determined within the range of 5 to 200 microns, the specific resistance is increased by 15 to 20 % but the thermal conductivity is reduced by 20 %.

According to the present invention, it is possible to produce a thermoelectric semiconductor material having a high mechanical strength and high reliability while preventing reduction of a figure of merit, by molding a sintered product of powder having an optimum grain size with fine grains removed therefrom.

In addition, according to the present invention, since the thermoelectric semiconductor material is not composed of a single crystal but a sintered product of powder having an optimum grain size with fine grains removed therefrom, a composition ratio of the thermoelectric semiconductor material can freely be selected, and moreover, a thermoelectric semiconductor material having a high figure of merit Z can be produced.

Additionally, since the ground powder is subjected to sieving so as to allow it to have an uniform grain size, doping control can be carried out easily. Once the sieved powder has an uniform grain size, powder grains are uniformly distributed along the grain boundary. Therefore, it is considered that reproducibility of an electron density is improved because electrons are constantly generated from the grain boundary.

Further, since a density of the sintered product of powder is increased by sieving the ground powder to have an uniform grain size, there is no possibility that properties of the thermoelectric semiconductor material are degraded due to penetration of a solder into the thermoelectric semiconductor material during a soldering step.

Moreover, since the molten mixture is quickly cooled down to a temperature lower than a solidification temperature of the molten mixture, an adequate grain size can be obtained with the sieved powder, and moreover, doping control can be carried out easily. In this connection, it should be noted that since the conventional method was practiced such that the molten mixture was quickly cooled down to about a room temperature, the grain boundary was excessively grown and enlarged, resulting in doping control being carried out with difficulty. In contrast with the conventional method, the method of the present invention makes it possible to easily carry out doping control.

It should be added that undesirable reduction of a yielding rate due to cracking or the like can substantially be prevented compared with a case where an ingot composed of a single crystal or a polycrytal is used for crushing and grounding it as it is.

## BRIEF DESCRIPTION OF THE DRAWINGS

Fig. 1 and Fig. 2 are graphs which illustrate a relationship between a Seebeck coefficient $\alpha$ and a specific resistance $\zeta$ appearing when impurity concentration in a sintered product of powder is varied in accordance preferred embodiments of the present invention, and Fig. 3 is a graph which illustrates a relationship between carrier concentration and thermoelectric properties of the sintered product.

## BEST MODE FOR CARRYING OUT THE INVENTION

Now, the present invention will be described in detail hereinafter with reference to the accompanying drawings which illustrate few preferred embodiments of the present invention.

EMBODIMENT 1

First, 335.64 g of bismuth Bi, 586.602 g of antimoni Sb and 1229.63 g of tellurium Te were weighed to prepare a mixture. After the mixture was received in a tube made of quartz, the tube was evacuated by driving a vacuum pump.

The tube was heated up to an elevated temperature of 650 °C and the molten mixture in the tube was stirred for three hours. Thereafter, the tube was displaced to a region having a temperature of 560 °C directly below a solidification temperature of the molten mixture in order to quickly cooling the molten mixture.

Next, after the resultant product of quickly cooled mixture was crushed and ground using a stamp mill, a ball mill or the like, the ground material was subjected to sieving by actuating a sifter including screens having mesh sizes of 200 and 400 so that powder having a grain size of about 26 to 74 microns was selectively prepared. Then, the powder was subjected to heat treatment in an atmosphere having 0.3 atmospheric pressure at a temperature of 350 °C for eight hours.

The powder of which grain size was selectively determined in the above-described manner was then subjected to hot pressing in a carbon die in which it was compacted in one direction in a vacuum or an inert gas atmosphere by employing a hot press process under conditions of a temperature of 500 °C and a pressure of 800 $kg/cm^2$, whereby a sintered product of powder was molded.

Subsequently, the sintered powder was cut into chips each having dimensions of 3 mm of width X 3 mm of thickness X 6 mm of length to form a sintered product of $Bi_{0.5}Sb_{1.5}Se_3$.

Properties of the sintered product of $Bi_{0.5}Sb_{1.5}Se_3$ are shown in Table 1 in comparison with those of a crystalline material.

Table 1

| | sintered material | | crystalline material | |
|---|---|---|---|---|
| Seebeck coefficient $\alpha$ ($\mu$ V/K) | + 190 | ± 0 | + 190 | Electrical properties (power factor were degraded by - 15 % but they were improved by 13 % in respect of K. Thus, The electrical properties were substantially equal to those of the crystalline material in respect of a figure of merit. |
| specific resistance $\rho$ (m Ω · cm) | 1.12 | + 1.5 % | 0.95 | |
| power factor $\alpha^2/\rho$ | $3.2 \times 10^{-5}$ | △ 15 % | $3.8 \times 10^{-5}$ | |
| thermal conductivity K(W/cmK) | $1.32 \times 10^{-2}$ | △ 13 % | $1.55 \times 10^{-2}$ | |
| figure of merit $Z(K^{-1})$ | $2.42 \times 10^{-3}$ | △ 1.2 % | $2.45 \times 10^{-3}$ | |

As is apparent from the results shown in the table, the sintered material of $Bi_{0.5}Sb_{1.4}Se_3$ derived from the first embodiment of the present invention has a specific resistance $\rho$ which is increased by 15 % but the thermal conductivity K of the same is decreased by 13 % in comparison with the crystalline material. As a result, the figure of merit Z of the sintered material is substantially equal to that of the crystalline material. In addition, it is found that the sintered product of the present invention has a very high mechanical strength.

With the thermoelectric power generating material of the present invention having properties as mentioned above, a mechanical property of the thermoelectric material can be increased without any reduction of the figure of merit. This advantage makes it easier to practically handle thermoelectric cooling elements with the aid of a certain machine when they are produced. Thus, productivity on mass production line can be improved, and moreover, these thermoelectric elements can be produced at a reduced cost.

EMBODIMENT 2

Next, a second embodiment of the present invention will be described below.

First, 313.5 g of bismuth Bi, 272.77 g of tellurium Te and 8.883 g of selenium Se were weighed to prepare a mixture, and iodine-antimoni $SbI_3$ was added to the mixture so as to adjust a carrier concentration as desired. After the mixture was received in a tube made of quartz, the tube was evacuated by driving a vacuum pump. Thus, a solid solution of $Bi_2Te_{2.85}Se_{0.15}$ + metal halide (iodine-antimoni) of 8.9 X $10^{18}cm^{-3}$ was produced, and powder having an uniform grain size was produced in the same manner as the first embodiment of the present invention. Then, the powder was subjected to hot pressing for 20 minutes under conditions of a temperature of 550 °C and a pressure of 1.8 ton/$cm^2$, whereby a sintered product of powder of n type $Bi_2Te_{2.85}Se_{0.15}$ was molded.

Properties of the sintered product of powder molded in that way are shown in Table 2 in comparison with a crystalline material having the same composition as that of the sintered product of powder.

Table 2

| | sintered material | | crystalline material | |
|---|---|---|---|---|
| Seebeck coefficient α (μV/K) | - 182 | Δ 12 % | - 207 | Electric properties (power fac- tor) were degraded by - 20 % but they were |
| specific resistance ρ (mΩ · cm) | 1.0 | Δ 5% | 1.05 | |
| power | | | | |

| factor $\alpha^2/\rho$ | $3.3 \times 10^{-5}$ | $\Delta$ 20 % | $4.1 \times 10^{-5}$ | improved by 20 % in respect of K. Thus, the electrical properties were substantially equal to those of the crystalline material in respect of a figure of merit. |
|---|---|---|---|---|
| thermal conductivity K(W/cmK) | $1.35 \times 10^{-2}$ | $\Delta$ 20 % | $1.67 \times 10^{-2}$ | |
| figure of merit $Z(K_{-1})$ | $2.45 \times 10^{-3}$ | $\pm$ 0 | $2.44 \times 10^{-3}$ | |

As is apparent from the results shown in the table, the sintered product of n type $Bi_2Te_{2.85}Se_{0.15}$ derived from the second embodiment has a figure of merit of 2.45 X $10^{-3}$/K which is substantially same to that of the crystalline material, i.e., 2.44 X $10^{-3}$/K.

With the sintered product of n type $Bi_2Te_{2.85}Se_{0.15}$ of the present invention, the substantially same Seebeck coefficient as that of the crystalline material can be maintained, resulting in a mechanical strength of the sintered product being remarkably improved with excellent reproducibility.

It should be added that a relationship between the Seebeck coefficient $\alpha$ and the specific resistance $\rho$ appearing when impurity concentration is varied depending on a quantity of addition of the metal halide $SbI_3$ or a quantity of addition of the tellurium Te is illustrated in Fig. 1 and Fig. 2.

As is apparent from the drawings, in the case of Te, when the impuritity concentration is increased to a level of $10^{21}$ per $cm^{-3}$, the Seebeck coefficient is decreased to a level of about 50 $\mu$V/K. When a quantity of addition of $SbI_3$ is set to 6 X $10^{20}$ /$cm^{-3}$, the Seebeck coefficient $\alpha$ is decreased to a level of 120 $\mu$V/K which is a half of the value obtained when the quantity of addition of $SbI_3$ is set to an order of $10^{19}$, resulting in properties of the sintered product being unavoidably degraded. Things are same with respect to the specific resistance $\rho$. For this reason, it is desirable that the impurity concentration is set to be $10^{21}$/$cm^{-3}$ or less.

Next, the sintered product of p type $Bi_{0.5}Sb_{1.5}Se_3$ in accordance with the first embodiment of the present invention was combined with the sintered material of n type $Bi_2Te_{2.85}Se_{0.15}$ in accordance with the second embodiment of the same to prepare a p-n element couple, and a maximum reduction of the temperature was measured with the p-n element couple.

Specifically, while a temperature $T_H$ of the p-n element couple on the heat generating side was maintained at a level of 27 °C, the p-n element couple was fed with an electric current and a temperature $T_C$ of the p-n element couple on the cooling side was then measured. After completion of the measurement, it was found that a maximum value $\Delta T_{max}$ of difference between the temperature $T_H$ and the temperature $T_C$ was recorded to amount to 66.5 K represented by an equation of $\Delta T_{max} = T_H - T_C = 66.5$ K. For the purpose of comparison, a maximum value $\Delta T_{max}$ of a p-n element couple constituted by a crystalline material having the same composition as that of the sintered product was measured and the results derived from the measurement revealed that it was 66.9 K and the sintered product has substantially same properties as those of the crystalline material.

In the second embodiment of the present invention, an iodine was used as an impurity. Alternatively, other V Group halogen element rather than the iodine may be used as an impurity.

EMBODIMENT 3

Next, a third embodiment of the present invention will be described below.

First, 78.38 g of bismuth, Bi, 136.98 g of antimoni Sb, 295.73 g of tellurium and 5.329 g of selenium Se were weighed to prepare a mixture. After the mixture was received in a tube made of quartz, the tube was evacuated by driving a vacuum pump. Then, powder of solid solution of $Bi_{0.5}Sb_{1.5}Te_{2.915}Se_{0.09}$ was prepared in the same manner as the first embodiment of the present invention. Subsequently, the powder was subjected to sieving to selectively adjust a grain size of the powder, and the powder having an uniform grain size was then subjected to hot pressing for 20 minutes under conditions of a temperature of 400 °C and a pressure of 400 kg/cm$^2$ to prepare a n type sintered product of $Bi_2Te_{2.85}Se_{0.15}$.

Properties of the sintered product prepared in that way are shown in Table 2 in comparison with a crystalline material having the same composition as that of the sintered product.

Table 3

| | sintered material | | crystalline material | |
|---|---|---|---|---|
| Seebeck coefficient $\alpha$ ($\mu$ V/K) | + 204 | ± 0 | + 204 | Electric properties (power factor) were degraded by |
| specific resistance | 1.05 | Δ 5% | 1.0 | |

| $\rho$ (m$\Omega$ · cm) | | | | - 5 % but they were improved by 11 % in respect of K. Thus, the electrical properties were substantially equal to those of the crystaline material in respect of a figure of merit. |
|---|---|---|---|---|
| power factor $\alpha^2/\rho$ | 4.0 X $10^{-5}$ | $\Delta$ 5 % | 4.2 X $10^{-5}$ | |
| thermal conductivity K(W/cmK) | 1.32 X $10^{-2}$ | $\Delta$ 11 % | 1.49 X $10^{-2}$ | |
| figure of merit Z($K^{-1}$) | 3.0 X $10^{-3}$ | + 7 % | 2.8 X $10^{-3}$ | |

As is apparent from the results shown in the table, the sintered product of p type $Bi_{0.5}Sb_{1.5}Te_{2.905}Se_{0.09}$ has a figure of meirt of 3.0 X $10^{-3}$/K which is substantially same to a figure of merit (2.8 X $10^{-3}$/K) of a crystalline material having the same composition as that of the sintered material.

With the sintered product of p type $Bi_{0.5}Sb_{1.5}Te_{2.915}Se_{0.09}$ of the present invention having properties as mentioned above, a figure of merit of the sintered product is maintained at the same level as the crystalline material, and moreover, a mechanical strength of the sintered product is remarkably improved with excellent reproducibility.

It should be added that properties of the sintered product of $Bi_{0.5}Sb_{1.5}Te_{2.95}Se_{0.09}$ can adequately be adjusted within the composition range represented by $Bi_{0.5}Sb_{1.5}(Te_{1-x}Se_x)_3$ + yTe ($0 \leqq x \leqq 0.2$, $0 \leqq y \leqq 0.2$).

In the third embodiment of the present invention, the sintered product of n type $Bi_2Te_{2.85}Se_{0.15}$ was subjected to hot pressing for 20 minutes under conditions of a temperature of 400 °C and a pressure of 400 kg/cm$^2$. It was found that when the pressure was increased to be higher than 2000 kg/cm$^2$, grain growth was recognized with the sintered product under conditions of a temperature of 350 °C and a compacting time of 10 minutes, causing a grain size to be increased slightly (it should be added that the sintered material was molten when the compacting pressure was excessively increased to be higher than 2300 kg/cm$^2$), and moreover, thermoelectric properties of the sintered product were improved by a quantity of about 8 % but the sintered product became more fragile than a single crystal. As a result, it was found that the sintered product could not be practically used.

A series of experiments were conducted to examine a temperature during a hot pressing operation for the sintered product. It was found from the results derived from the experiments that when the temperature during the hot pressing operation was elevated in excess of 600 °C, grain growth was recognized, causing a grain size to be slightly increased but the sintered material became more fragile than the single crystal. As a result, it was found that the sintered product could not be practically used.

As will be apparent from the above description, it is desirable that a sintering temperature for the sintered product is determined within the range of about 350 °C to 600 °C and a compacting pressure for the same is determined within the range of about 400 $kg/cm^2$ to 2000 $kg/cm^2$.

To practice each of the embodiments of the present invention, there is employed a method wherein materials are heated and chemically molten together, and thereafter, the resultant molten mixture is quickly cooled down to a temperature slightly lower than a solidification temperature of the molten mixture.

In contrast with the foregoing method of the present invention, there has been hitherto employed a method wherein the molten mixture is quickly cooled down to about a room temperature in order to avoid an occurrence of segregation. In this case, there arises an occasion that a grain boundary is excessively grown and enlarged due to the presence of fine crystals in the sintered product, resulting in doping control being carried out with difficulty. In contrast with the conventional method, the method of the present invention makes it possible to obtain an adequate grain size with the sintered product.

In addition, to practice each of the embodiments of the present invention, a grain size of powder employable for the sintered product was selectively determined to remain within the range of about 26 to 74 microns. Alternatively, the grain size may adequately be selected within the range of 10 to 200 microns. If the grain size is smaller than 10 microns, the grain boundary is excessively grown and enlarged, resulting in doping control being carried out with difficulty. Additionally, since a degree of displacement of grains is reduced due to undesirable distribution of carriers along the grain boundary, properties of the sintered product are degraded. Further, since powder is liable to readily aggregate, it is difficult to handle the powder material. On other hand, if the grain size is larger than 200 microns, a sufficiently high mechanical strength of the sintered product can not be obtained, and moreover, a sufficiently high density can not be obtained with the sintered product.

INDUSTRIAL APPLICABILITY

A thermoelectric material of the present invention is used for a Peltier element or the like by jointing two different kinds of electrically conductive materials to each other to form a p-n junction. Thus, the thermoelectric material is very advantageously employable as a device for practically operating optoelectronic apparatuses, semiconductor laser light apparatuses or the like at a constant temperature.

## Claims

**1.** A thermoelectric semiconductor material characterized in that said thermoelectric semiconductor material is composed of a sintered product of monoconductive type powder containing as a main component powder of solid solution of tellurium-bismuth ($Bi_2Te_3$) and tellurium-antimoni($Sb_2Te_3$) having an uniform grain size.

**2.** A thermoelectric semiconductor material as claimed in claim 1, characterized in that said grain size remains within the range of 10 to 200 microns.

**3.** A thermoelectric semiconductor material characterized in that said thermoelectric semiconductor material is composed of a sintered product of monoconductive type powder containing as a main component powder of solid solution of tellurium-bismuth ($Bi_2Te_3$), tellurium-antimoni ($Sb_2Te_3$) and selenium-antimoni ($Sb_2Se_3$) having an uniform grain size.

**4.** A thermoelectric semiconductor material as claimed in claim 3, characterized in that said grain size remains within the range of 10 to 200 microns.

**5.** A thermoelectric semiconductor material as claimed in claim 1, characterized in that a halogen element or a V Group element is added to said sintered product of powder as an impurity by a quantity of $10^{21}cm^{-3}$ or less.

**6.** A method of producing a thermoelectric semiconductor material, characterized in that said method comprises the following steps, i.e.,

a step of mixing bismuth, antimoni, tellurium, selenium and monoconductive type impurities with each other while maintaining a desired composition and then heating and melting the resultant mixture,

a step of quickly cooling the molten mixture to prepare a solid solution in the form of an ingot,

a step of crushing and grinding the resultant ingot to prepare powder of said solid solution,

a step of sieving said power of solid solution so as to allow said powder of solid solution to have an uniform grain size, and

a step of sintering said powder of solid solution having an uniform grain size.

**7.** A method of producing a thermoelectric semiconductor material as claimed in claim 6, characterized in that said cooling step is a step of quickly cooling the molten mixture down to a temperature lower than a solidification temperature of the molten mixture.

**8.** A method of producing a thermoelectric semiconductor material as claimed in claim 6, characterized in that said sintering step is a step of sintering said powder of solid solution having an uniform grain size while compacting it in one direction.

**9.** A method of producing a thermoelectric semiconductor material as claimed in claim 8, characterized in that said sintering step is carried out under conditions of a temperature of 350 °C to 600 °C and a pressure of 400 $kg/cm^2$ to 2000 $kg/cm^2$.

|α| (μ V/K)
1000
200
100
20
10
SbJ3
Te
10^19
10^20
10^21
1/cm^3
(IMPURITY CONCENTRATION)
|ρ| ( m Ω · cm)
10
2
1
0.2
0.1
SbJ3
Te
10^19
10^20
10^21
1/cm^3
(IMPURITY CONCENTRATION)

FIG. 1

FIG. 2

SEMICONDUCTOR
METAL
FIGURE OF MERIT Z(10^3K^-1)
SEEBECK COEFFICIENT a(mV K^-1) a^2δ(10^2W K^-2m^-1)
ELECTRIC CONDUCTIVITY log d(Ω^-1m^-1)
THERMAL CONDUCTIVITY κ(W K^-1m^-1)
a
Z
a^2δ
δ=1/ρ
κ
κph
CARRIER CONCENTRATION log n (m^-1)
21
22
23
24
25
26
27
28

FIG. 3

# INTERNATIONAL SEARCH REPORT

International Application No PCT/JP90/00777

**I. CLASSIFICATION OF SUBJECT MATTER** (if several classification symbols apply, indicate all) [6]

According to International Patent Classification (IPC) or to both National Classification and IPC

Int. Cl$^5$ H01L35/16, H01L35/18

**II. FIELDS SEARCHED**

Minimum Documentation Searched [7]

| Classification System | Classification Symbols |
|---|---|
| IPC | H01L35/16, H01L35/18 |

Documentation Searched other than Minimum Documentation to the Extent that such Documents are Included in the Fields Searched [8]

Jitsuyo Shinan Koho 1926 - 1990
Kokai Jitsuyo Shinan Koho 1971 - 1990

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| Y | JP, A, 64-77184 (Teikoku Piston Ring Co., Ltd.), 23 March 1989 (23. 03. 89), (Family: none) | 1 - 9 |
| X | JP, A, 64-37456 (Komatsu Electronics K.K.), 8 February 1989 (08. 02. 89), (Family: none) | 1 - 9 |
| Y | JP, A, 64-2379 (Idemitsu Petro-Chemical Co., Ltd.), 6 January 1989 (06. 01. 89), (Family: none) | 1 - 9 |
| Y | JP, A, 1-106478 (Mitsui Mining & Smelting Co., Ltd.), 24 April 1989 (24. 04. 89), (Family: none) | 1 - 9 |

* Special categories of cited documents: [10]
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

**IV. CERTIFICATION**

| Date of the Actual Completion of the International Search | Date of Mailing of this International Search Report |
|---|---|
| August 28, 1990 (28. 08. 90) | September 17, 1990 (17. 09. 90) |
| **International Searching Authority** | **Signature of Authorized Officer** |
| Japanese Patent Office | |